# EUROPÄISCHE PATENTSCHRIFT

(11) **EP 3 281 287 B1**
(45) Veröffentlichungstag und Bekanntmachung des Hinweises auf die Patenterteilung: **28.07.2021**
(21) Anmeldenummer: 16729845.4
(22) Anmeldetag: 08.06.2016
(51) Int. Cl.: H02M 1/088, H02M 7/00

(54) **SCHNELLSCHALTENDE SCHALTUNGSANORDNUNG FÜR EINEN UMRICHTER**
FAST-SWITCHING CIRCUIT ASSSEMBLY FOR A CONVERTER
SYSTÈME DE CIRCUIT À COMMUTATION RAPIDE POUR CONVERTISSEUR

(30) Priorität: 12.06.2015 DE 102015210802
(43) Veröffentlichungstag der Anmeldung: 14.02.2018
(73) Patentinhaber: Siemens Aktiengesellschaft, 80333 München (DE)
(72) Erfinder: BLUM, Manuel, 85521 Ottobrunn (DE); FINKENZELLER, Michael, 80687 München (DE); KIFFE, Walter, 85551 Kirchheim (DE); KOMMA, Thomas, 85521 Ottobrunn (DE); POEBL, Monika, 81667 München (DE)
(86) Internationale Anmeldenummer: PCT/EP2016/063053
(87) Internationale Veröffentlichungsnummer: WO 2016/198461

(56) Entgegenhaltungen:
- US-A- 5 170 337
- US-A1- 2005 179 472
- US-A1- 2012 268 091
- US-A1- 2013 241 520
- HOFER P ET AL: "Paralleling intelligent IGBT power modules with active gate-controlled current balancing", POWER ELECTRONICS SPECIALISTS CONFERENCE, 1996. PESC '96 RECORD., 27TH ANNUAL IEEE; [PESC RECORD: ANNUAL IEEE POWER ELECTRONICS SPECIALISTS CONFERENCE. FORMERLY POWER CONDITIONING SPECIALISTS CONFEREN , 23 June 1996 (1996-06-23), XP002619276, ISBN: 978-0-7803-3501-1 Retrieved from the Internet: URL:http://ieeexplore.ieee.org/stamp/stamp .jsp?tp=&arnumber=548751&tag=1 [retrieved on 2011-01-28]

## Beschreibung

Die Erfindung betrifft eine Schaltungsanordnung für einen elektrischen Umrichter. Die Schaltungsanordnung weist mehrere Schalteinheiten auf, von denen jede einen Halbleiterschalter und eine Gate-Treiberschaltung zum Steuern des Halbleiterschalters aufweist. Zu der Erfindung gehört auch ein elektrischer Umrichter mit der erfindungsgemäßen Schaltungsanordnung.

Bei Umrichtern für die Leistungselektronik können die Halbleiterschalter des Gleichrichters und/oder Wechselrichters eines Umrichters als Modul bereitgestellt werden. Ein solches Modul weist dann beispielsweise drei Halbbrücken auf, die aus den Halbleiterschaltern gebildet sind. Zum Steuern der Halbleiterschalter wird dieses Modul mit einer getrennten Schaltungsplatine verschaltet, auf welcher die Gate-Treiberschaltungen für die Halbleiterschalter realisiert sind. Die Schaltungsplatine wird an das Modul mittels Drähten an Steuereingängen angeschlossen. Innerhalb des Moduls sind die Steuereingänge mit den Gates der Halbleiterschalter über Bonding-Drähte verschaltet.

Die bei dieser Modultechnik auftretenden modulinternen Verdrahtungsinduktivitäten begrenzen die maximal mögliche Schaltfrequenz, mit welcher die Halbleiterschalter geschaltet werden können. Wird die maximale Schaltfrequenz überschritten, kommt es zur Induktion von Überspannungen durch die Verdrahtungsinduktivitäten. Um Beschädigung des Halbleiters zu verhindern, müssen daher die Schaltfrequenz und die Schaltgeschwindigkeit (das heißt der Übergang zwischen dem leitenden und dem nichtleitenden Schaltzustand) niedrig gehalten werden.

Hierzu beschreibt die US 2013/241520 A1 einen Chip mit zumindest einem Leistungsschalter und mit einer Treibereinheit zum Erzeugen eines Treibersignals zum Ansteuern des zumindest einen Leistungsschalters. Dabei umfasst die Treibereinheit eine oder mehrere Schaltungseinheiten, welche auf demselben Substrat ausgebildet sind wie der zumindest einen Leistungsschalter.

Dokument US 2012/268091 beschreibt einen Chip mit zwei Schaltern Q1 und Q2. Der Schalter Q1 dient dazu, die Stromänderungs-Geschwindigkeit zu begrenzen. Der zweite, später zugeschaltete Schalter Q2 dient dazu, den Durchlasswiderstand niedrig zu halten.

Des Weiteren offenbart die US 2005/179472 A1 eine Halbleitervorrichtung mit einem High-Side-Schaltelement, einer Treiberschaltung und einem Low-Side-Schaltelement. Dabei ist die Treiberschaltung auf einem ersten Halbleitersubstrat ausgebildet, auf dem auch das High-Side-Schaltelement ausgebildet ist, und treibt das High-Side-Schaltelement an.

Ferner beschreibt die US 5 170 337 A ein Halbleiterbauelementpaket, umfassend ein elektrisch isolierendes Substrat, und zumindest eine Gruppe von parallel gekoppelten Schaltvorrichtungen, die elektrisch verbunden sind. Dabei ist es vorgesehen, dass die Schaltvorrichtungen so angeordnet sind, dass die Drähte zwischen den Schaltvorrichtungen und korrespondierenden Anschlüssen die gleiche Länge aufweisen.

Die Druckschrift HOFER P ET AL: "Paralleling intelligent IGBT power modules with active gate-controlled current balancing", POWER ELECTRONICS SPECIALISTS CONFERENCE, 1996. PESC '96 RECORD., 27TH ANNUAL IEEE; [PESC RECORD: ANNUAL IEEE POWER ELECTRONICS SPECIALISTS CONFERENCE. FORMERLY POWER CONDITIONING SPECIALISTS CONFEREN, 23. Juni 1996 (1996-06-23), XP002619276, ISBN: 978-0-7803-3501-1 beschreibt die parallele Anordnung mehrerer modular aufgebauter Schaltungseinheiten. Ein Modul umfasst dabei zwei in Reihe geschaltete IGBTs. Zur Erhöhung der Stromabgabe können die IGBT-Chips mehrerer Module parallel geschaltet und deren Treiberschaltungen entsprechend angesteuert werden.

Der Erfindung liegt die Aufgabe zugrunde, einen Umrichter mit hoher Schaltfrequenz und/oder Schaltgeschwindigkeit bereitzustellen.

Die Aufgabe wird durch die Gegenstände der unabhängigen Patentansprüche gelöst. Vorteilhafte Weiterbildungen der Erfindung ergeben sich durch die Merkmale der abhängigen Patentansprüche.

Die Erfindung umfasst eine Schaltungsanordnung für einen elektrischen Umrichter. Bei der Schaltungsanordnung sind jeweils ein Halbleiterschalter und seine Gate-Treiberschaltung zum Steuern des Halbleiterschalters zu einer Schalteinheit zusammengefasst. Um diese Schalteinheit schnell zu schalten, also mit einer hohen Schaltfrequenz und/oder hohen Schaltgeschwindigkeit betreiben zu können, ist erfindungsgemäß vorgesehen, dass bei jeder Schalteinheit jeweils der Halbleiterschalter und die Gate-Treiberschaltung auf einer gemeinsamen Trägerplatine angeordnet sind und der Gate-Treiberschalter über zumindest eine Leiterbahn der Trägerplatine mit dem Gate des Halbleiterschalters elektrisch verbunden ist.

Durch die Erfindung ergibt sich der Vorteil, dass die Gate-Treiberschaltung nicht über einen Draht an ein Modul angeschlossen werden muss und dann innerhalb des Moduls über einen weiteren Bonding-Draht die Verbindung zum Gate des Halbleiterschalters hergestellt wird. Diese verhältnismäßig lange Wegstrecke zwischen der Gate-Treiberschaltung und dem Gate verursacht die beschriebene Verdrahtungsinduktivität. Bei der erfindungsgemäßen Schaltungsanordnung können dagegen die Gate-Treiberschaltung und das Gate durch die gemeinsame Anordnung auf der Trägerplatine einen geringen Abstand aufweisen, so dass über die Leiterbahn keine signifikante Vergrößerung der Induktivität entsteht. Durch die Erfindung ergibt sich somit der Vorteil, dass die Verdrahtungsinduktivität zwischen der Gate-Treiberschaltung und dem Gate bei jeder Schalteinheit nicht mehr der begrenzende Faktor beim Einstellen der maximalen Schaltfrequenz und/oder Schaltgeschwindigkeit darstellt. Damit kann die Schaltungsanordnung schneller schaltend betrieben werden als eine herkömmliche Umrichter-Schaltungsanordnung, die auf dem eingangs beschriebenen Modul basiert. Unter schnellem Schalten wird insbesondere eine Schaltfrequenz größer als 50kHz verstanden.

Die erfindungsgemäße Schaltungsanordnung ist insbesondere als Leistungselektronik ausgelegt, das heißt jeder Halbleiterschalter ist bevorzugt dazu ausgelegt, einen Nennstrom von größer als 10 Ampere, insbesondere größer als 50 Ampere, über seine Schaltstrecke (Drain-Source-Verbindung) zu führen oder schalten. Eine Sperrspannung der Schaltstrecke jedes Halbleiterschalters ist insbesondere größer als 100 Volt.

Erfindungsgemäß wird es ermöglicht, einen besonders großen Strom zu schalten. Hierzu sind zumindest zwei der Schalteinheiten parallel geschaltet. Um dann dennoch trotz der verteilt angeordneten Gate-Treiberschaltungen dieser beiden Schalteinheiten ein synchrones Schalten zu ermöglichen, ist eine zentrale Logikschaltung mit der jeweiligen Gate-Treiberschaltung der zumindest zwei parallelen Schalteinheiten verschaltet. Die Logikschaltung ist dazu ausgelegt, in Abhängigkeit von einem Schaltsignal die Gate-Treiberschaltungen gleichzeitig anzusteuern. Die zentrale Logikschaltung kann hierbei in einem größeren Abstand zu beiden Gate-Treiberschaltungen bereitgestellt sein, da sich hier keine Probleme mit der Verdrahtungsinduktivität ergeben. Somit ist hierdurch in vorteilhafter Weise weiterhin eine zentrale Steuerung der Gate-Treiberschaltungen ermöglicht und dennoch der Einfluss von Verdrahtungsinduktivitäten durch das Anordnen der Gate-Treiberschaltungen an den Halbleiterschaltern vermieden.

Jede der Schalteinheiten muss nicht auf einer separaten Platine angeordnet sein. Die Erfindung sieht stattdessen vor, dass die zumindest zwei parallel geschalteten Schalteinheiten auf derselben Trägerplatine angeordnet sind. Hierdurch ergibt sich der Vorteil, dass eine besonders raumsparende Schaltungsanordnung bereitgestellt sein kann. Im Zusammenhang mit den parallel geschalteten Schalteinheiten ergibt sich der Vorteil, dass das Aufteilen des geschalteten Stromes mittels der Trägerplatine realisiert werden kann.

Zu der Erfindung gehören auch optionale Weiterbildungen, durch deren Merkmale sich zusätzliche Vorteile ergeben.

Eine besonders geringe Verdrahtungsinduktivität ergibt sich bei einer Weiterbildung, bei welcher bei den Schalteinheiten jeweils ein Abstand der Gate-Treiberschaltung von dem Gate des Halbleiterschalters kleiner als 2 Zentimeter, insbesondere kleiner 1 Zentimeter, ist.

Eine Weiterbildung sieht vor, dass die Halbleiterschalter der Schalteinheiten auf einer Wide-Bandgap-Halbleitertechnologie basieren. Insbesondere sind die Halbleiterschalter auf der Basis von Siliziumcarbid und/oder Galliumnitrid hergestellt. Durch diese Weiterbildung ergibt sich der Vorteil, dass die Halbleiterschalter eine größere Schaltfrequenz und/oder Schaltgeschwindigkeit aufweisen als beispielsweise Silizium-Halbleiterschalter. Die Halbleiterschalter können hierbei beispielsweise als IGBT (Insulated Gate Bipolar Transistor) oder MOSFET (metal oxide semiconductor field effect transistor) ausgestaltet sein. Somit ist bei dieser Weiterbildung auch der Halbleiterschalter selbst mit einer größeren Maximalfrequenz betreibbar als ein herkömmlicher Silizium-basierter Halbleiterschalter.

Um die Schaltungsanordnung möglichst aufwandsarm zu realisieren, sieht eine Weiterbildung vor, dass die Halbleiterschalter der Schalteinheiten jeweils durch ein diskretes Bauelement bereitgestellt sind. Dieses Bauelement stellt also einen Halbleiterschalter dar, der in einem eigenen Gehäuse angeordnet ist. Dieses Bauelement ist dann mit der Schaltungsplatine verlötet.

Bei einer Weiterbildung ist bei zumindest einer der Schalteinheiten der Schaltstrecke des Halbleiterschalters eine Snubber-Schaltung parallel geschaltet. Eine Snubber-Schaltung kann beispielsweise als durch ein RC-Glied gebildet sein. Hierdurch ergibt sich der Vorteil, dass auch weitere Induktivitäten kompensiert werden können.

Die Halbleiterschalter der Schalteinheiten und insbesondere auch eine Snubber-Schaltung können im Betrieb Wärme entwickeln, die abgeführt werden muss. Eine Weiterbildung der Erfindung sieht vor, dass bei zumindest einer der Schalteinheiten die Trägerplatine ein IMS (insulated metal substrate - isoliertes Metallsubstrat) aufweist. Hierdurch ergibt sich der Vorteil, dass die Wärme durch die Isolierung hindurch über das Metall des IMS abgeführt werden kann. Insbesondere wird das IMS in der Kombination mit der Snubber-Schaltung verwendet.

Um Schwingungen zwischen parallel geschalteten Halbleiterschaltern zu unterdrücken, kann vorgesehen sein, dass die parallel geschalteten Halbleiterschalter durch Schalteinheiten bereitgestellt, die auf einer gemeinsamen Trägerplatine angeordnet sind. Hierdurch kann dann in vorteilhafter Weise durch Anordnung der Schalteinheiten auf der Trägerplatine und die sich hieraus ergebenden Strompfadlängen ein Dämpfungseffekt bei den Schwingungen bewirkt werden. Ein weiterer Parameter zum Beeinflussen der Schwingungsneigung oder des Schwingungsverhaltens von parallel geschalteten Halbleitern ist die Wahl der Ansteuersignale oder Steuersignale für die Gates.

Zu der Erfindung gehört auch ein Umrichter, bei welchem der Wechselrichter und/oder der Gleichrichter jeweils eine Schaltungsanordnung aufweist, die eine Ausführungsform der erfindungsgemäßen Schaltungsanordnung darstellt. Der erfindungsgemäße Umrichter kann in vorteilhafter Weise schnellschaltend betrieben werden, ohne dass hierbei die Halbleiterschalter der Schalteinheiten durch induzierte Überspannungen beschädigt werden.

Gemäß einer Weiterbildung ist eine Steuereinrichtung des Umrichters dazu ausgelegt, die jeweiligen Schaltungsanordnungen des Wechselrichters und/oder des Gleichrichters mit einer Schaltfrequenz zu betreiben, die größer als 50kHz ist. Herkömmliche Umrichter sind dagegen nur in der Lage, eine Schaltfrequenz kleiner als 20kHz zu schalten.

Im Folgenden sind Ausführungsbeispiele der Erfindung beschrieben. Hierzu zeigt:
- FIG 1: eine schematische Darstellung einer Ausführungsform des erfindungsgemäßen Umrichters,
- FIG 2: eine schematische Darstellung einer Ausführungsform der erfindungsgemäßen Schaltungsanordnung,
- FIG 3: eine schematische Darstellung einer alternativen Ausführungsform der erfindungsgemäßen Schaltungsanordnung und
- FIG 4: eine schematische Darstellung einer weiteren Ausführungsform der erfindungsgemäßen Schaltungsanordnung.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

In den Figuren sind funktionsgleiche Elemente jeweils mit denselben Bezugszeichen versehen.

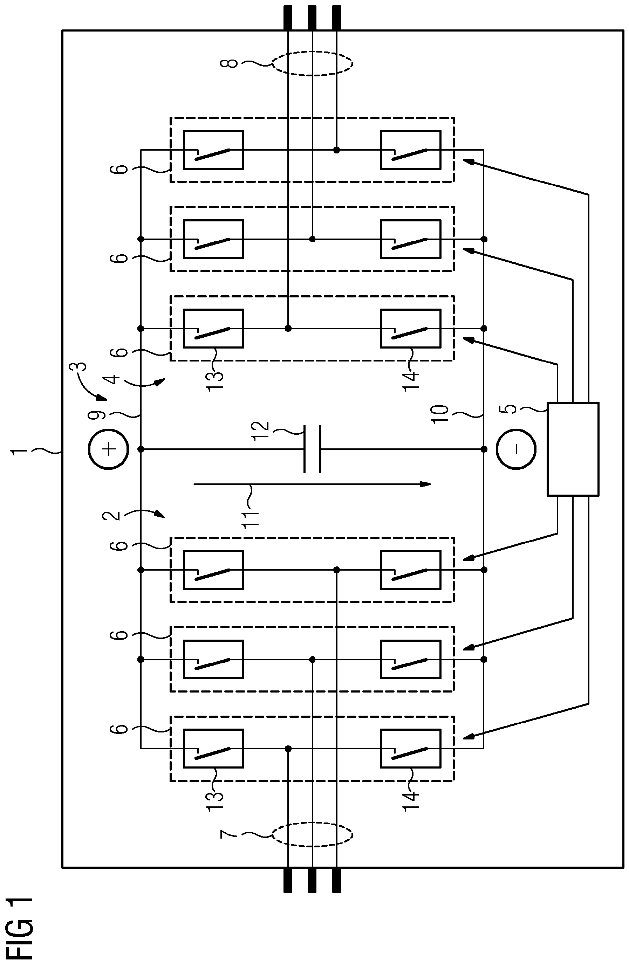

FIG 1 zeigt einen Umrichter 1 mit einem Gleichrichter 2, einem Gleichspannungs-Zwischenkreis oder kurz Zwischenkreis 3, einem Wechselrichter 4 und einer Steuereinrichtung 5. Der Gleichrichter 2 und der Wechselrichter 4 können jeweils Halbbrücken 6 aufweisen, über welche Wechselspannungs-Phasenleitungen oder kurz Phasenleitungen 7, 8 des Umrichters 1 in bekannter Weise mit sowohl einer Plus-Leitung 9 als auch einer Minus-Leitung 10 des Zwischenkreises 3 verschaltet sind. Durch den Gleichrichter 2 kann aus den Wechselspannungen der Phasenleitungen 7 mittels der Halbbrücken 6 in an sich bekannter Weise in dem Zwischenkreis 3 eine Gleichspannung 11 erzeugt werden, die in einem Zwischenkreiskondensator 12 gepuffert werden kann. Durch den Wechselrichter 4 können aus der Gleichspannung 11 in den Phasenleitern 8 jeweils Wechselspannungen mittels der Halbbrücken 6 erzeugt werden.

Der Umrichter 1 kann beispielsweise zum Betreiben einer elektrischen Maschine, beispielsweise einer Synchronmaschine, vorgesehen sein. Der Umrichter 1 kann hierzu über die Phasenleitungen 7 mit einem elektrischen Versorgungsnetz verschaltet sein und über die Phasenleitungen 8 mit der elektrischen Maschine verschaltet sein.

Bei dem Umrichter 1 werden die Halbbrücken 6 durch die Steuereinrichtung 5 geschaltet oder angesteuert. Die Schaltungseinrichtung 5 kann beispielsweise durch elektrische und elektronische Bauelemente gebildet sein. Es kann auch jeweils
eine separate Steuereinrichtung für den Gleichrichter 2 und den Wechselrichter 4 vorgesehen sein. Die Schaltungseinrichtung 5 kann beispielsweise durch einen Mikroprozessor oder einen ASIC (application specific integrated circuit) gebildet sein.

Die Halbbrücken weisen jeweils eine sogenannte High-Side-Schaltung 13 und eine Low-Side-Schaltung 14 auf, von denen in der FIG 1 der Übersichtlichkeit halber nur einige mit einem Bezugszeichen versehen sind. Die Schaltungen 13, 14 können dabei jeweils einen oder eine Parallelschaltung aus mehreren Halbleiterschaltern aufweisen.

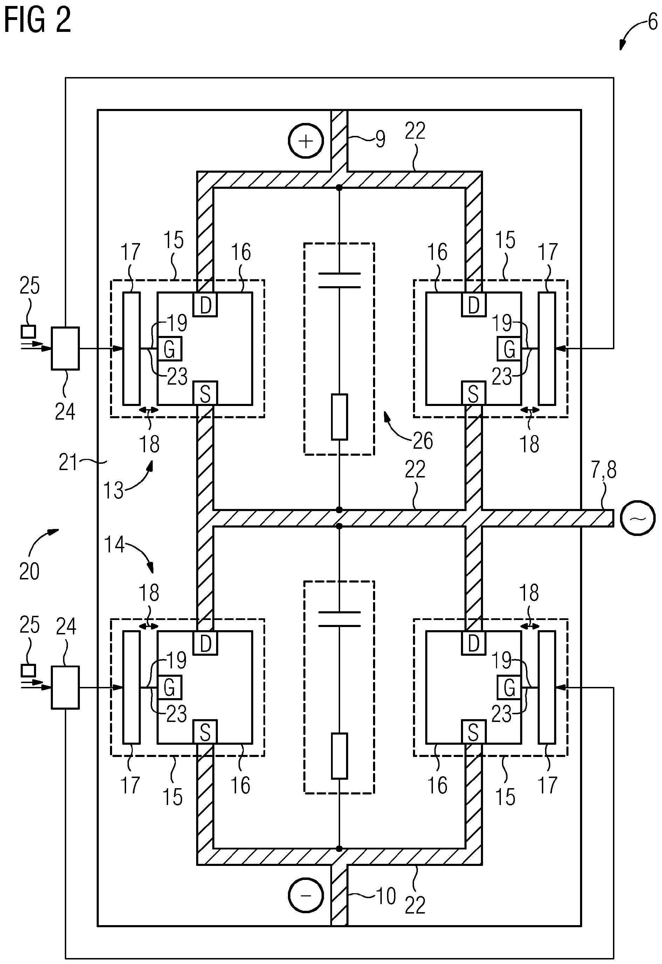

In FIG 2 ist eine Halbbrücke 6 noch einmal genauer dargestellt. In dem in FIG 2 veranschaulichten Beispiel weisen die High-Side-Schaltung 13 und die Low-Side-Schaltung 14 jeweils parallel geschaltete Schalteinheiten 15 auf. Jede Schalteinheit 15 weist einen Halbleiterschalter 16 und eine Gate-Treiberschaltung oder kurz Treiberschaltung 17 für den jeweiligen Halbleiterschalter 16 auf. Zur Veranschaulichung sind von den Halbleiterschaltern 16 jeweils die Anschlüsse Drain D, Source S und Gate G dargestellt. Bei dem Halbleiterschalter 16 kann es sich beispielsweise jeweils um einen IGBT oder MOSFET handeln. Die Halbleiterschalter 16 sind insbesondere auf einer Wide-Bandgap-Halbleitertechnologie basierend ausgestaltet, insbesondere handelt es sich um Siliziumcarbid- und/oder Galliumnitridbasierte Halbleiterschalter oder Transistoren.

Bei den Gate-Treiberschaltungen kann es sich jeweils um eine Schaltung handeln, wie sie an sich aus dem Stand der Technik als Gate-Treiber bekannt ist. Durch die Gate-Treiberschaltung wird beim Schalten des jeweiligen Halbleiterschalters 16 eine Gate-Kapazität des Gates G umgeladen. Bei den Halbbrücken 6 des Umrichters 1 ist dies mit einer besonders hohen Schaltfrequenz und/oder Schaltgeschwindigkeit möglich. Insbesondere ist eine Schaltfrequenz größer als 50kHz ermöglicht.

Hierzu ist ein Abstand 18 zwischen den Treiberschaltungen 17 und dem zugehörigen Halbleiterschalter 16 derart gering, dass eine Steuerleitung 19, durch welche die Treiberschaltung 17 mit dem Gate G verbunden ist, kurz ausgeschaltet ist und hierdurch eine geringe Verdrahtungsinduktivität ausbildet. Insbesondere beträgt der Abstand 18 weniger als 2 Zentimeter.

Um diese niederinduktive Anordnung aus Treiberschaltung 17 und Halbleiterschalter 16 zu ermöglichen, ist in dem in FIG 2 gezeigten Beispiel die Halbbrücke 6 als eine Schaltungsanordnung 20 ausgestaltet, die dadurch gekennzeichnet ist, dass bei jeder Schalteinheit 15 die Treiberschaltung 17 und der Halbleiterschalter 16 auf einer gemeinsamen Trägerplatine 21 angeordnet sind. In dem in FIG 2 gezeigten Beispiel sind sämtliche Schalteinheiten 15 auf einer gemeinsamen Trägerplatine 21 angeordnet. Die Trägerplatine 21 ist insbesondere eine Platte, die beispielsweise als PCB (printed circuit board) ausgestaltet sein kann. Die Trägerplatine 21 kann insbesondere als IMS ausgestaltet sein.

Auf der Trägerplatine 21 können Leiterbahnen 22 oder Kupferbahnen oder Aluminiumbahnen angeordnet sein, durch welche
eine Verbindung der Schalteinheiten 15 mit der Plus-Leitung 9, der Minus-Leitung 10 und den jeweiligen Phasenleitern 7, 8 bereitgestellt sein kann. Bei der Schaltungsanordnung 8 ist insbesondere auch die Steuerleitung 19 durch eine Leiterbahn 23 auf der Trägerplatine 21 gebildet.

Zum gleichzeitigen Schalten der jeweils parallel geschalteten Halbleiterschalter 16 über deren Treiberschaltung 17 kann bei der Schaltungsanordnung 20 jeweils eine Treiberlogik oder Logikschaltung 24 bereitgestellt sein, welche ein Steuersignal 25 der Steuereinheit 5 an die beiden Treiberschaltungen 17 der parallel geschalteten Schalteinheiten 15 weiterleitet. Die Logikschaltung 24 kann einen Steuerschaltkreis zum Koordinieren der Schaltzeitpunkte der Schalteinheiten 15 aufweisen.

Zu den parallel geschalteten Halbleiterschaltern 16 kann des Weiteren optional eine Snubber-Schaltung 26 parallel geschaltet sein. Es kann jeweils eine Snubber-Schaltung 26 für jeden Halbleiterschalter 16 oder eine gemeinsame Snubber-Schaltung 26 vorgesehen sein. Eine Snubber-Schaltung 26 kann beispielsweise durch einen an sich bekannten Snubber-Kondensator oder ein RC-Glied oder durch einen Kondensator allein gebildet sein.

Die Schaltungsanordnung 20 kann dazu ausgestaltet sein, einen Strom mit einer Stromstärke in einem Bereich von mehr als 50 Ampere, insbesondere mehr als 100 Ampere, zu führen. Durch die gezeigte Parallelschaltung ist es hierbei möglich, dass jeder Halbleiterschalter 16 nur dazu ausgelegt ist, einen Teilstrom als Nennstrom zu führen, so dass der Nennstrom jedes Halbleiterschalters 16 kleiner ist als der Nennstrom der Schaltungsanordnung 25. Eine Sperrspannung der Halbleiterschalter 16 kann größer als 100 Volt sein.

Die Treiberschaltungen 17 können jeweils mit der Steuereinrichtung 5 über eine galvanische Trenneinrichtung, z.B. einen Optokoppler, gekoppelt sein. Hierdurch ist auch bei hohen Sperrspannungen an der Drain-Source-Schaltstrecke der Halbleiterschalter 16 trotz der Nähe der Treiberschaltung 17 ein Übertreten der Sperrspannung auf die Steuereinrichtung 5 verhindert.

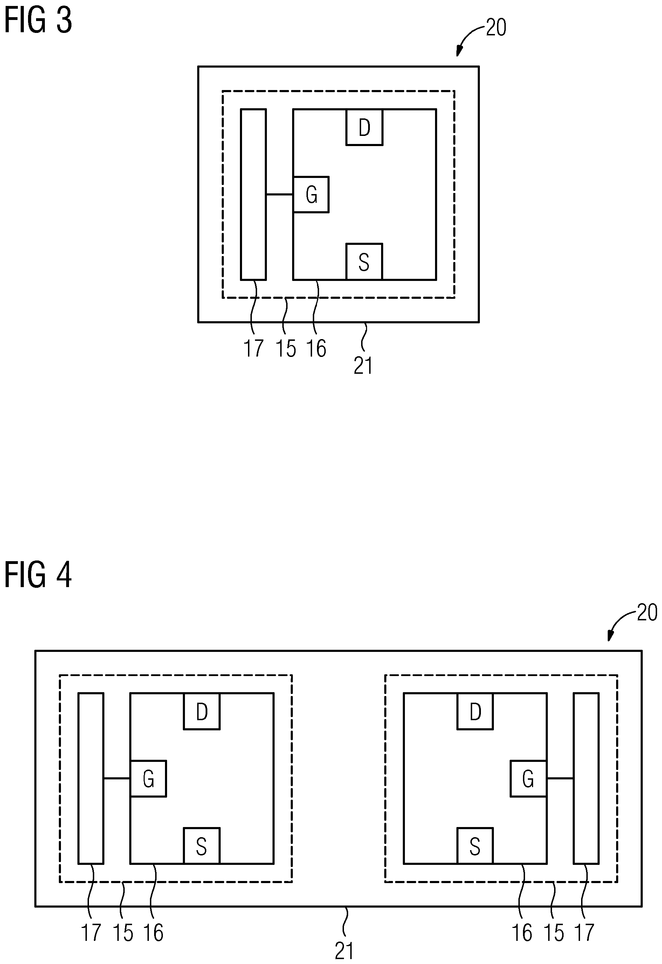

In FIG 3 ist eine alternative Ausführungsform der Schaltungsanordnung dargestellt. Bei dieser Schaltungsanordnung 20 ist eine einzelne Schalteinheit 15 mit einem Halbleiterschalter 16 und einer Treiberschaltung 17 auf einer eigenen Trägerplatine 21 ohne eine weitere Schalteinheit 15 angeordnet. Die Trägerplatine 21 kann in derselben Weise ausgestaltet sein, wie bereits im Zusammenhang mit FIG 2 beschrieben worden ist. Vorteil dieser Anordnung ist, dass der Gleichrichter 7 oder der Wechselrichter 8 auf Grundlage der Schaltungsanordnung 20 gemäß FIG 3 besonders flexibel in einen zur Verfügung stehenden Bauraum eingepasst werden kann.

FIG 4 zeigt eine weitere Ausführungsform der Schaltungsanordnung 20, bei welcher zwei Schalteinheiten 15 auf einer gemeinsamen Trägerplatine 21 angeordnet sind. Durch (nicht gezeigte) Leiterbahnen der Trägerplatine 21 können die Schalteinheiten 15 parallel geschaltet sein. Es kann auch vorgesehen sein, dass mehr als zwei Schalteinheiten 15 auf einer gemeinsamen Trägerplatine 21 als Parallelschaltung bereitgestellt sind. Hierdurch kann in vorteilhafter Weise durch Wahl der Anzahl der Schalteinheiten der Betrag des Nennstroms eingestellt werden, der durch die Schaltungsanordnung 20 geschaltet werden kann.

Durch die Beispiele ist gezeigt, dass die Halbleiterschalter 16 nicht als separates, einteiliges Modul bereitgestellt sein müssen, welches dann mit einer weiteren Schaltungsplatine verschaltet werden muss, auf welchem sich sämtliche Treiberschaltungen für die Halbleiterschalter des gesamten Moduls befinden. Anstelle eines großen Moduls werden diskrete Leistungshalbleiter auf einer Leiterplatte verschaltet und mit einem separaten Treiber niederinduktiv verbunden. Durch die niederinduktive Anbindung können Schaltüberspannungen verhindert und die Schaltgeschwindigkeit erhöht werden. Ein Schwingen zwischen den parallelen Halbleitern wird durch optimiertes Layout der Leiterbahnen 22, 23 und korrekte Ansteuerung durch die Steuereinheit 5 unterbunden. Bei Bedarf können Snubber-Schaltungen ideal an den Halbleiter angebunden und bei Einsatz von IMS auch ideal entwärmt werden.

Mit einem optimalen Layout von Treiber und Leistungshalbleiter ist die Erhöhung der Schaltfrequenz auch für größere Leistungsbereiche möglich. Die Kombination aus niederinduktiven Halbleitergehäusen, IMS-Leiterplattentechnologie und zugeschnittener Treiberperipherie ermöglicht somit die Ausnutzung der sich insbesondere durch Wide-Bandgap-Halbleiter ergebenden Vorteile.

Insgesamt zeigt das Beispiel, wie durch die Erfindung ein HF-Umrichtermodul bereitgestellt werden kann.

## Patentansprüche

1. Schaltungsanordnung (20) für einen elektrischen Umrichter (1), mit Schalteinheiten (15), von denen jede jeweils einen Halbleiterschalter (16) und eine Gate-Treiberschaltung (17) zum Steuern des Halbleiterschalters (16) aufweist, wobei bei jeder Schalteinheit (15) jeweils der Halbleiterschalter (16) und die Gate-Treiberschaltung (17) auf einer gemeinsamen Trägerplatine (21) angeordnet sind und die Gate-Treiberschaltung (17) über zumindest eine Leiterbahn (23) der Trägerplatine (21) mit einem Gate (G) des Halbleiterschalters (16) elektrisch verbunden ist,
**dadurch gekennzeichnet, dass**
eine Logikschaltung (24) mit der jeweiligen Gate-Treiberschaltung (17) von zumindest zwei parallel geschalteten Schalteinheiten (15) verschaltet und dazu ausgelegt ist, in Abhängigkeit von einem Schaltsignal (25) die Gate-Treiberschaltungen (17) gleichzeitig anzusteuern, um ein synchrones Schalten der Gate-Treiberschaltungen (17) zu ermöglichen, wobei
die zumindest zwei parallel geschalteten Schalteinheiten (15) auf derselben Trägerplatine (21) angeordnet sind.

2. Schaltungsanordnung (20) nach Anspruch 1, wobei bei den Schalteinheiten (15) jeweils ein Abstand (18) der Gate-Treiberschaltung (17) von dem Gate (G) kleiner als 2 Zentimeter, insbesondere kleiner als 1 Zentimeter, ist.

3. Schaltungsanordnung (20) nach einem der vorhergehenden Ansprüche, wobei die Halbleiterschalter (16) der Schalteinheiten (15) auf einer Wide-Bandgap-Halbleitertechnologie, insbesondere auf Siliziumcarbid und/oder Galliumnitrid, basieren.

4. Schaltungsanordnung (20) nach einem der vorhergehenden Ansprüche, wobei die Halbleiterschalter (16) der Schalteinheiten (15) jeweils durch ein diskretes Bauelement bereitgestellt sind, welches mit der Schaltungsplatine (21) verlötet ist.

5. Schaltungsanordnung (20) nach einem der vorhergehenden Ansprüche, wobei bei zumindest einer der Schalteinheiten (15) einer Schaltstrecke des Halbleiterschalters (16) eine Snubber-Schaltung (26) parallel geschaltet ist.

6. Schaltungsanordnung (20) nach einem der vorhergehenden Ansprüche, wobei bei zumindest einer der Schalteinheiten (15) die Trägerplatine (21) ein IMS, insulated metal substrate, aufweist.

7. Umrichter (1), bei welchem ein Wechselrichter (4) und/oder ein Gleichrichter (2) jeweils eine Schaltungsanordnung (20) nach einem der vorhergehenden Ansprüche aufweist.

8. Umrichter (1) nach Anspruch 7, wobei eine Steuereinrichtung (5) dazu ausgelegt ist, die jeweilige Schaltungsanordnung (20) des Wechselrichters (4) und/oder des Gleichrichters (2) mit einer Schaltfrequenz zu betreiben, die größer als 50kHz ist.

## Claims

1. Circuit assembly (20) for an electrical converter (1), comprising switching units (15), each of which respectively having a semiconductor switch (16) and a gate driver circuit (17) for controlling the semiconductor switch (16), wherein, in each switching unit (15), the respective semiconductor switch (16) and gate driver circuit (17) are arranged on a common carrier circuit board (21), and the gate driver circuit (17) is electrically connected to a gate (G) of the semiconductor switch (16) by means of at least one printed conductor (23) of the carrier circuit board (21),
**characterized in that**
a logic circuit (24) is interconnected with the respective gate driver circuit (17) of at least two parallel-connected switching units (15) and is designed for the simultaneous actuation of the gate driver circuits (17), in response to a switching signal (25) in order to make possible synchronous switching of the gate driver circuits (17), wherein
the at least two parallel-connected switching units (15) are arranged on the same carrier circuit board (21).

2. Circuit assembly (20) according to Claim 1, wherein, in the switching units (15), a respective clearance (18) between the gate driver circuit (17) and the gate (G) is smaller than 2 centimetres, in particular smaller than 1 centimetre.

3. Circuit assembly (20) according to one of the preceding claims, wherein the semiconductor switches (16) of the switching units (15) are based on a wide-bandgap semiconductor technology, in particular on silicon carbide and/or gallium nitride.

4. Circuit assembly (20) according to one of the preceding claims, wherein the semiconductor switches (16) of the switching units (15) are each constituted as a discrete component, which is soldered to the circuit board (21).

5. Circuit assembly (20) according to one of the preceding claims, wherein, in at least one of the switching units (15), a snubber circuit (26) is connected in parallel with a switching path of the semiconductor switch (16).

6. Circuit assembly (20) according to one of the preceding claims, wherein, in at least one of the switching units (15), the carrier circuit board (21) has an IMS, or insulated metal substrate.

7. Converter (1), in which an inverter (4) and/or a rectifier (2) respectively comprise a circuit assembly (20) according to one of the preceding claims.

8. Converter (1) according to Claim 7, wherein a control device (5) is designed to operate the respective circuit assembly (20) of the inverter (4) and/or of the rectifier (2) at a switching frequency which is greater than 50 kHz.

## Revendications

1. Montage (20) d'un convertisseur (1) électrique, comprenant des unités (15) de coupure, dont chacune a respectivement un interrupteur (16) à semi-conducteur et un circuit (17) d'attaque de grille pour la commande de l'interrupteur (16) à semi-conducteur, dans lequel pour chaque unité (15) de coupure respectivement l'interrupteur (16) à semi-conducteur et le circuit (17) d'attaque de grille sont montés sur une platine (21) de support commune et le circuit (17) d'attaque de grille est relié électriquement à une grille (G) de l'interrupteur (16) à semi-conducteur au moyen d'une piste (23) conductrice de la platine (21) de support,
**caractérisé en ce que**
un circuit (24) logique est connecté au circuit (17) d'attaque de grille respectif d'au moins deux unités (15) de coupure montées en parallèle et est conçu pour commander en fonction d'un signal (25) de coupure simultanément les circuits (17) d'attaque de grille, afin de permettre une connexion synchrone des circuits (17) d'attaque de grille, dans lequel
les au moins deux unités (15) de coupure montées en parallèle sont montées sur la même platine (21) de support.

2. Montage (20) suivant la revendication 1 dans lequel dans les unités (15) de coupure respectivement une distance (18) des circuits (17) d'attaque de grille à la grille (G) est plus petite que 2 centimètres, notamment plus petite que 1 centimètre.

3. Montage (20) suivant l'une des revendications précédentes dans lequel les interrupteurs (16) à semi-conducteur des unités (15) de coupure reposent sur une technologie de semi-conducteur wide-bandgap, notamment sur carbure de silicium et/ou nitrure de gallium.

4. Montage (20) suivant l'une des revendications précédentes, dans lequel les interrupteurs (16) à semi-conducteur des unités (15) de coupure sont mis à disposition respectivement par un composant discret, qui est brasé à la platine (21) de support.

5. Montage (20) suivant l'une des revendications précédentes, dans lequel pour au moins l'une des unités (15) de coupure, un circuit (26) snubber est monté en parallèle à une section de coupure de l'interrupteur (16) à semi-conducteur.

6. Montage (20) suivant l'une des revendications précédentes dans lequel dans au moins l'une des unités (15) de coupure la platine (21) de support a un IMS, Insulated Métal Substrate.

7. Convertisseur (1), dans lequel un onduleur (4) et/ou un redresseur (2) a respectivement un montage (20) suivant l'une des revendications précédentes.

8. Convertisseur (1) suivant la revendication 7, dans lequel un dispositif (5) de commande est conçu pour faire fonctionner le montage (20) respectif de l'onduleur (4) et/ou du redresseur (2) a une fréquence de coupure, qui est plus grande que 50kHz.
